# EUROPEAN PATENT APPLICATION

(11) **EP 4 447 090 A1**
(43) Date of publication of application: **16.10.2024**
(21) Application number: 22917852.0
(22) Date of filing: 07.01.2022

(54) **MEMORY AND ELECTRONIC DEVICE**

(71) Applicant: Huawei Technologies Co., Ltd., Shenzhen, Guangdong 518129 (CN)
(72) Inventor: HUANG, Kailiang, Shenzhen, Guangdong 518129 (CN); JING, Weiliang, Shenzhen, Guangdong 518129 (CN); FENG, Junxiao, Shenzhen, Guangdong 518129 (CN); WANG, Zhengbo, Shenzhen, Guangdong 518129 (CN)
(74) Representative: Pfenning, Meinig & Partner mbB
(86) International application number: PCT/CN2022/070811
(87) International publication number: WO 2023/130380

(57) **Abstract**

This application discloses a memory and an electronic device. The memory may include at least one layer of memory array and a transistor array disposed in a stacked manner with the at least one layer of memory array. Each layer of memory array includes a plurality of memory cells. The transistor array may include a plurality of transistor groups arranged in a first direction, each transistor group includes a plurality of transistors arranged at an equal distance in a second direction, and adjacent transistor groups are arranged in a staggered manner in the second direction. Each transistor in the transistor group is correspondingly electrically connected to one memory cell in each memory array, and the first direction is perpendicular to the second direction. In the memory, the transistors in the transistor array are arranged in a cellular manner. In comparison with a regular matrix arrangement of the transistor array, this can increase a quantity of transistors per unit area, to reduce a horizontal projection area of a single transistor, improve a density of the memory cells in the memory array, and increase a storage capacity of the memory.

## Description

### TECHNICAL FIELD

This application relates to the field of storage technologies, and in particular, to a memory and an electronic device.

### BACKGROUND

A memory (memory) is a memory device used to store information in modern information technologies. With a rapid increase of data volume in the current intelligent society, a requirement for a capacity of the memory is rapidly increasing. These applications of large-capacity storage have an increasingly high requirement for a memory cell density of a memory array. However, a planar memory is limited by a physical size of a memory cell, and a storage density increase gradually stops. Therefore, a large-capacity memory has developed toward three-dimensional integration. A three-dimensional integrated memory includes a transistor array and a three-dimensional memory array, where the transistor array is used to control site selection and read/write operations of the three-dimensional memory array. A horizontal projection area of the three-dimensional memory array is mainly determined based on a horizontal projection area of the transistor array, and a storage density of the memory is determined based on the horizontal projection area of the three-dimensional memory array. Therefore, how to design and optimize the transistor array has become one of key problems in implementing a high-density three-dimensional memory.

### SUMMARY

This application provides a memory and an electronic device. A storage capacity of the memory can be increased by using a transistor array arranged in a cellular manner.

According to a first aspect, this application provides a memory. The memory may include at least one layer of memory array, and a transistor array disposed in a stacked manner with the at least one layer of memory array. Each layer of memory array in the at least one layer of memory array includes a plurality of memory cells. The transistor array may include a plurality of transistor groups arranged in a first direction, each transistor group includes a plurality of transistors arranged at an equal distance in a second direction, and adjacent transistor groups are arranged in a staggered manner in the second direction. Each transistor in the transistor group is correspondingly electrically connected to one memory cell in each memory array, and the first direction is perpendicular to the second direction.

In the memory, in the plurality of transistor groups arranged in the first direction in the transistor array, each transistor group includes the plurality of transistors arranged at an equal distance in the second direction, and the adjacent transistor groups are arranged in the staggered manner in the second direction. Therefore, transistors in the transistor array are arranged in a cellular manner. In comparison with a regular matrix arrangement of the transistor array, this can increase a quantity of transistors per unit area, to reduce a horizontal projection area of a single transistor, improve a density of memory cells in the memory array, and increase a storage capacity of the memory.

In the memory, each layer of memory array corresponds to a plurality of selection signal lines, and the memory may further include a plurality of first control lines and a plurality of second control lines. Each selection signal line is electrically connected to at least one memory cell in a corresponding memory array, each transistor is electrically connected to one first control line and one second control line, and at least one control line of first control lines and second control lines that are electrically connected to any two transistors is different.

In this way, one transistor may be selected based on the first control line and the second control line, to select a plurality of memory cell strings electrically connected to the transistor, and then a single memory cell is selected by using the selection signal line.

For example, in this application, a distance at which transistors at corresponding positions in the adjacent transistor groups are staggered in the second direction is equal to half of a distance between centers of two adjacent transistors in a same transistor group. For example, a distance between centers of two adjacent transistors in a same transistor group is S. For adjacent transistor groups Am and Am+1, a distance that is in the second direction and that is between a center of an n^{th} transistor in the second direction in the transistor group Am and a center of an n^{th} transistor in the second direction in the transistor group Am+1 is equal to S/2.

Further, in the transistor array, for the adjacent transistor groups, a distance between centers of the transistors belonging to different transistor groups in the first direction is equal to the distance between centers of two adjacent transistors in a same transistor group. In this way, in this application, if a distance between centers of any two adjacent transistors is equal to 2F, a horizontal projection area of a single transistor may reach about 3.46F². Therefore, in comparison with a related technology in which a horizontal projection area of a single transistor is 4F², this can reduce the horizontal projection area of the single transistor in the transistor array, improve the density of memory cells in the memory array, and increase the storage capacity of the memory.

It should be noted that, in embodiments of this application, a concept of the "equal distance" is not completely equal in a strict sense. In a memory preparation process, due to impact of a preparation process and a preparation device, there may be a case in which distances are not strictly completely equal. This case is caused by a specific preparation process, and it cannot be indicated that the case in which the distances are not strictly completely equal goes beyond the protection scope of this application.

Optionally, in this application, an arrangement manner of the memory cells in the memory array is the same as an arrangement manner of the transistors in the transistor array. In other words, the memory cells in the memory array are arranged in the cellular manner.

For example, in this application, for a plurality of selection signal lines corresponding to each layer of memory array, for ease of cabling, the plurality of selection signal lines may be arranged in the second direction, and each selection signal line extends in the first direction. Certainly, during specific implementation, the plurality of selection signal lines may alternatively be arranged in the first direction, and each selection signal line extends in the second direction. This is not limited herein.

During specific implementation, in this application, for the plurality of selection signal lines corresponding to each layer of memory array, the plurality of selection signal lines may be disposed in parallel. For selection signal lines corresponding to different memory arrays, the selection signal lines corresponding to different memory arrays may be disposed in parallel, or may be disposed vertically. This is not limited herein.

It should be noted that, in embodiments of this application, a concept of the "parallel" is not completely equal in a strict sense. In the memory preparation process, due to the impact of the preparation process and the preparation device, there may be a case in which selection signal lines are not strictly parallel. This case is caused by the specific preparation process, and it cannot be indicated that the case in which the selection signal lines are not strictly parallel goes beyond the protection scope of this application. In addition, similar understanding is also provided for position relationships such as "perpendicular" and "an included angle is a specific angle". Details are not described herein again.

Further, in this application, the plurality of selection signal lines corresponding to each layer of memory array may be interconnected. In this way, the plurality of selection signal lines corresponding to each layer of memory array may be electrically connected to a peripheral circuit through one cable. In other words, in this application, for each layer of memory array, only one cable is needed to implement interconnection to the peripheral circuit, so that a quantity of cables can be reduced, and an occupied area of the memory can be reduced.

It may be understood that the transistor usually includes a gate electrode, a source electrode, and a drain electrode. When the gate electrode controls the transistor to be conducted, the source electrode and the drain electrode are conducted, and the source electrode and the drain electrode may be interchanged. Among the three electrodes of the transistor, one electrode is electrically connected to the memory cell, the 2^{nd} electrode is electrically connected to the first control line, and the last electrode is electrically connected to the second control line.

For example, the gate electrode of the transistor is electrically connected to the second control line, the source electrode or the drain electrode of the transistor is electrically connected to the first control line, and the drain electrode or the source electrode of the transistor is electrically connected to the memory cell. Alternatively, the gate electrode of the transistor is electrically connected to the memory cell, the source electrode or the drain electrode of the transistor is electrically connected to the first control line, and the drain electrode or the source electrode of the transistor is electrically connected to the second control line.

It should be noted that a structure of the memory cell is not limited in this application. For example, the memory cell may be a dynamic storage structure, a floating gate storage structure, a ferroelectric storage structure, a resistive storage structure, a phase change storage structure, a magnetic storage structure, or an electrochemical storage structure.

Optionally, in this application, the transistor may include a gate electrode, a gate oxygen medium, a semiconductor channel material, a first electrode, an insulation medium, and a second electrode. The gate electrode includes a columnar portion extending in a stacking direction of the memory and a planar portion located at one end of the columnar portion. The gate oxygen medium and the semiconductor channel material sequentially wrap an outer side of the columnar portion. The first electrode surrounds or partially surrounds the semiconductor channel material, and the first electrode is located near the planar portion. The second electrode is located at one end of the columnar portion away from the planar portion, and the second electrode and the columnar portion are spaced by the gate oxygen medium and the semiconductor channel material. The insulation medium is disposed between the first electrode and the second electrode to electrically isolate the first electrode from the second electrode.

It should be noted that, in this application, the first electrode may be the source electrode, and the second electrode is the drain electrode. Alternatively, the first electrode is the drain electrode, and the second electrode is the source electrode.

In this application, two ends of the transistor in the stacking direction are respectively the gate electrode and the second electrode. Therefore, the memory array may be stacked on one end of the gate electrode of the transistor and directly electrically connected to the gate electrode, or may be stacked on one end of the second electrode of the transistor and directly electrically connected to the second electrode. In this way, no additional area needs to be added for interconnection between the memory array and the transistor, and flexibility of the interconnection between the transistor and the memory array can be improved. This is applicable to high-density storage devices with different readout manners.

During specific implementation, the memory array is located on one side of the gate electrode of the transistor, the gate electrode of the transistor is electrically connected to the corresponding memory cell, the first electrode of the transistor is electrically connected to the second control line, and the second electrode of the transistor is electrically connected to the first control line. Alternatively, the memory array is located on one side of the second electrode of the transistor, the second electrode of the transistor is electrically connected to the corresponding memory cell, the first electrode of the transistor is electrically connected to the first control line, and the gate electrode of the transistor is electrically connected to the second control line.

Further, the stacking direction of the memory array is not limited in this application. The memory array may be stacked above the transistor array, or the transistor array may be stacked above the memory array.

To facilitate cabling and reduce difficulty in peripheral circuit design, in this application, the plurality of first control lines may be arranged in the first direction, each first control line extends in the second direction, and each first control line is correspondingly electrically connected to one transistor group. For example, in this application, the plurality of first control lines may be disposed in parallel.

Further, in this application, the plurality of second control lines may be arranged in the second direction, and each second control line extends in the first direction. Each transistor in the transistor group corresponds to one second control line, transistor groups located at odd-numbered positions in the first direction share a second control line, and transistor groups located at even-numbered positions in a first direction share a second control line.

Optionally, the second control line is in a straight line shape, and the second control line electrically connected to each transistor group that is located at an odd-numbered position in the first direction is different from the second control line electrically connected to each transistor group that is located at an even-numbered position in the first direction.

Further, to increase a distance between adjacent second control lines, to reduce impact of parasitic capacitance, the second control line is in a straight line shape or a sawtooth shape, and two adjacent rows of transistors in the second direction share the second control line.

In this application, to increase the distance between adjacent second control lines, in another embodiment, the plurality of second control lines are arranged in a third direction, and each second control line extends in a fourth direction. The third direction is perpendicular to the fourth direction, and an included angle between the fourth direction and the second direction is 60 degrees. Each transistor in the transistor group corresponds to one second control line, and each transistor group located at an odd-numbered position in the first direction and each transistor group located at an even-numbered position in the first direction share at least a part of the second control line.

Optionally, in this application, the second control lines may be disposed in parallel. In this way, it can be ensured that the distance between the adjacent second control lines is equal everywhere, and preparation difficulty can be reduced.

In this application, an arrangement manner of each layer of memory array is the same as an arrangement manner of the transistor array. In other words, a position of a memory cell electrically connected to each transistor is the same as a position of the transistor, and each memory cell electrically connected to each transistor is stacked above or below the transistor.

Based on a same technical idea, the cellularly arranged transistor array provided in the example of this application may be used in a 2T0C memory. In the memory, each layer of memory array is formed by stacking two layers of transistor arrays. A single memory cell in the memory array includes two transistors. A second electrode of one transistor is connected to a gate electrode of the other transistor, and the memory cell may store information by using a capacitor of a connection node of the two transistors. In the memory, because transistor arrays forming the memory array are arranged in the cellular manner, memory cells in the memory array are arranged in the cellular manner. In comparison with a regular matrix arrangement of the transistor array, this can increase a quantity of memory cells per unit area in the memory array, to reduce a horizontal projection area of a single memory cell, improve the density of memory cells in the memory array, and increase the storage capacity of the memory. For a specific implementation of the memory, refer to an embodiment shown in the second aspect.

According to a second aspect, this application provides another memory. The memory may include at least one layer of memory array. Each layer of memory array in the at least one layer of memory array corresponds to a plurality of first control lines, a plurality of second control lines, a plurality of third control lines, and a plurality of fourth control lines. Each memory array in the at least one layer of memory array includes a plurality of memory cell groups arranged in a first direction. Each memory cell group includes a plurality of memory cells arranged at an equal distance in a second direction, adjacent memory cell groups are arranged in a staggered manner in the second direction, and the first direction is perpendicular to the second direction. Each memory cell includes a first transistor and a second transistor that are disposed in a stacked manner, and a gate electrode of the first transistor is electrically connected to a second electrode of the second transistor. A second electrode and a first electrode of each first transistor are electrically connected to one first control line and one second control line respectively, and at least one control line of first control lines and second control lines that are electrically connected to any two first transistors is different. A gate electrode and a first electrode of each second transistor are electrically connected to one third control line and one fourth control line respectively, and at least one control line of third control lines and fourth control lines that are electrically connected to any two second transistors is different.

In this application, each memory array is formed by two layers of transistor arrays. One layer of transistor array is formed by first transistors arranged in a cellular manner, and the other layer of transistor array is formed by second transistors arranged in the cellular manner. A memory array is formed by using two layers of transistor arrays. Each memory cell in the memory array corresponds to one first control line, one second control line, one third control line, and one fourth control line. Therefore, each layer of memory array can implement site selection by using the first control line, the second control line, the third control line, and the fourth control line, and no additional transistor array needs to be disposed for a stacked memory array. Therefore, in the memory, a storage density of the memory array may be determined based on a horizontal projection area of a single memory cell in the memory array. In the memory, each memory cell group in the memory array includes the plurality of memory cells arranged at an equal distance in the second direction, and adjacent memory cell groups are arranged in the staggered manner in the second direction. Therefore, the memory cells in the memory array are arranged in the cellular manner. In comparison with a regular matrix arrangement, this can increase a quantity of memory cells per unit area, to reduce a horizontal projection area of a single memory cell, improve a density of memory cells in the memory array, and increase a storage capacity of the memory.

For example, in the memory array, a distance at which memory cells at corresponding positions in the adjacent memory cell groups are staggered in the second direction is equal to half of a distance between centers of two adjacent memory cells in a same memory cell group. For example, a distance between centers of any two adjacent memory cells in a memory cell group Bm is S, and for adjacent memory cell groups Bm and Bm+1, a distance at which memory cells at corresponding positions in the second direction are staggered in the second direction Y is equal to S/2. In other words, a distance that is in the second direction Y and that is between a center of an n^{th} memory cell in the memory cell group Bm in the second direction and a center of an n^{th} memory cell in the memory cell group Bm+1 in the second direction is equal to S/2.

Further, in the memory array, in the adjacent memory cell groups, a distance between centers that are of the memory cells belonging to different memory cell groups and that are in the first direction is equal to the distance between centers of two adjacent memory cells in a same memory cell group. In this way, in this application, if a distance between centers of any two adjacent memory cells is equal to 2F, a horizontal projection area of a single memory cell may reach about 3.46F². Therefore, in comparison with a related technology in which a horizontal projection area of a single memory cell is 4F², this can reduce the horizontal projection area of the single memory cell, improve the density of memory cells in the memory array, and increase the storage capacity of the memory.

During specific implementation, in this application, one of the first control line and the second control line that are interconnected to the first transistor may be a bit line, and the other may be a word line. This is not limited herein. Similarly, one of the third control line and the fourth control line that are interconnected to the second transistor may be a bit line, and the other may be a word line. This is not limited herein.

Optionally, in the memory, both the first transistor and the second transistor include a gate electrode, a gate oxygen medium, a semiconductor channel material, a first electrode, an insulation medium, and a second electrode. The gate electrode includes a columnar portion extending in a stacking direction of the memory and a planar portion located at one end of the columnar portion. The gate oxygen medium and the semiconductor channel material sequentially wrap an outer side of the columnar portion. The first electrode surrounds or partially surrounds the semiconductor channel material, and the first electrode is located near the planar portion. The second electrode is located at one end of the columnar portion away from the planar portion, and the second electrode and the columnar portion are spaced by the gate oxygen medium and the semiconductor channel material. The insulation medium is disposed between the first electrode and the second electrode to electrically isolate the first electrode from the second electrode. However, the gate electrode of the first transistor is disposed facing the second electrode of the second transistor, and the gate electrode of the first transistor is electrically connected to the second electrode of the second transistor.

It should be noted that, in this application, the first electrode of the first transistor may be a source electrode, and the second electrode is a drain electrode. Alternatively, the first electrode is a drain electrode, and the second electrode is a source electrode. Similarly, the first electrode of the second transistor may be a source electrode, and the second electrode is a drain electrode. Alternatively, the first electrode is a drain electrode, and the second electrode is a source electrode.

During specific implementation, in the memory cell, the first transistor may be stacked above the second transistor, or certainly, the second transistor may be stacked above the first transistor. This is not limited herein.

To facilitate cabling and reduce difficulty in peripheral circuit design, in this application, the plurality of first control lines may be arranged in the first direction, each first control line extends in the second direction, and each first control line is correspondingly electrically connected to one memory cell group. The plurality of third control lines are arranged in the first direction, each third control line extends in the second direction, and each third control line is correspondingly electrically connected to one memory cell group.

For example, in this application, the plurality of first control lines may be disposed in parallel, and the plurality of third control lines may be disposed in parallel.

For example, in this application, the plurality of second control lines may be arranged in the second direction, and each second control line extends in the first direction. Each first transistor in the memory cell group corresponds to one second control line, memory cell groups located at odd-numbered positions in the first direction share a second control line, and memory cell groups located at even-numbered positions in the first direction share a second control line.

Correspondingly, in this application, the plurality of fourth control lines may be arranged in the second direction, and each fourth control line extends in the first direction. Each second transistor in the memory cell group corresponds to one fourth control line, memory cell groups located at odd-numbered positions in the first direction share a fourth control line, and memory cell groups located at even-numbered positions in a first direction share the fourth control line.

In a feasible implementation, in this application, the second control line is in a straight line shape, and the second control line electrically connected to each memory cell group located at an odd-numbered position in the first direction is different from the second control line electrically connected to each memory cell group located at an even-numbered position in the first direction.

In a feasible implementation, in this application, the fourth control line is in a straight line shape, and the fourth control line electrically connected to each memory cell group located at an odd-numbered position in the first direction is different from the fourth control line electrically connected to each memory cell group located at an even-numbered position in the first direction.

Further, to increase a distance between adjacent second control lines, to reduce impact of parasitic capacitance, in this application, the second control line is in a straight line shape or a sawtooth shape, and two adjacent rows of memory cells in the second direction share the second control line.

Further, to increase a distance between adjacent fourth control lines, to reduce the impact of the parasitic capacitance, in this application, the fourth control line is in a straight line shape or a sawtooth shape, and two adjacent rows of memory cells in the second direction share the fourth control line.

In this application, to increase the distance between adjacent second control lines, in another embodiment, the plurality of second control lines may be arranged in a third direction, and each second control line extends in a fourth direction. An included angle between the fourth direction and the second direction is 60 degrees, and the third direction is perpendicular to the fourth direction. Each first transistor in the memory cell group corresponds to one second control line, and each memory cell group located at an odd-numbered position in the first direction and each memory cell located at an even-numbered position in the first direction share at least a part of the second control line.

In this application, to increase the distance between adjacent second control lines, in another embodiment, the plurality of fourth control lines are arranged in a third direction, and each fourth control line extends in a fourth direction. An included angle between the fourth direction and the second direction is 60 degrees, and the third direction is perpendicular to the fourth direction. Each second transistor in the memory cell group corresponds to one fourth control line, and each memory cell group located at an odd-numbered position in the first direction and each memory cell group located at an even-numbered position in the first direction share at least a part of the fourth control line.

Optionally, in this application, the second control lines may be disposed in parallel. In this way, it can be ensured that the distance between the adjacent second control lines is equal everywhere, and preparation difficulty can be reduced. Correspondingly, the fourth control lines may alternatively be disposed in parallel. In this way, it can be ensured that the distance between the adjacent fourth control lines is equal everywhere, and preparation difficulty can be reduced.

According to a third aspect, this application further provides an electronic device. The electronic device may include a processor, and the memory that is coupled to the processor and that is provided in any one of the implementations of the first aspect and the second aspect.

For a technical effect that can be achieved in the third aspect, refer to the descriptions of the technical effect that can be achieved in any possible design of the first aspect and the second aspect. Details are not described herein again.

### BRIEF DESCRIPTION OF DRAWINGS

FIG. 1 is a diagram of a structure of a conventional transistor array;
FIG. 2 is a diagram of an example of a structural framework of a memory according to an embodiment of this application;
FIG. 3 is a diagram of an example of a structural framework of another memory according to an embodiment of this application;
FIG. 4 is a diagram of an example of a partial structure of a memory according to an embodiment of this application;
FIG. 5 is a diagram of an example of an arrangement of a transistor array according to an embodiment of this application;
FIG. 6a and FIG. 6b are respectively diagrams of examples of cross-sectional structures of a transistor in an AA' direction according to an embodiment of this application;
FIG. 7a and FIG. 7b are respectively diagrams of examples of cross-sectional structures of another transistor in an AA' direction according to an embodiment of this application;
FIG. 8 is a diagram of an example of a structure of a memory array according to an embodiment of this application;
FIG. 9 is a diagram of an example of a structure of a transistor array according to an embodiment of this application;
FIG. 10 is a diagram of an example of a structure of a transistor array according to an embodiment of this application;
FIG. 11 is a diagram of an example of a structure of a transistor array according to an embodiment of this application;
FIG. 12 is a diagram of an example of a structure of a transistor array according to an embodiment of this application;
FIG. 13 is a diagram of an example of a structural framework of a memory according to an embodiment of this application;
FIG. 14 is a diagram of an example of a structural framework of another memory according to an embodiment of this application;
FIG. 15 is a diagram of an example of a structure of another memory according to an embodiment of this application;
FIG. 16 is a diagram of an example of a structural framework of another memory according to an embodiment of this application;
FIG. 17 is a diagram of an example of a cross-sectional structure of a memory cell in an AA' direction according to an embodiment of this application; and
FIG. 18 is a diagram of an example of a structure of an electronic device according to an embodiment of this application.

### DESCRIPTION OF EMBODIMENTS

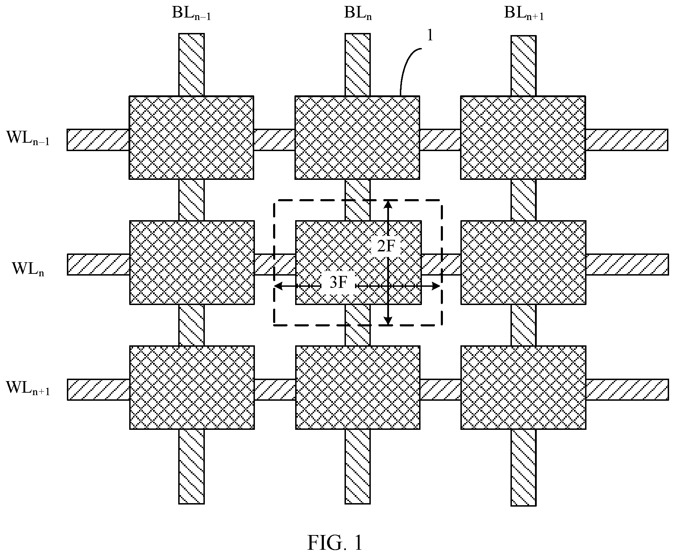

With continuous evolution of the semiconductor technologies, currently, large-capacity memories have developed toward three-dimensional integration. A three-dimensional integrated memory includes a transistor array and a three-dimensional memory array, where the transistor array is used to control site selection and read/write operations of the three-dimensional memory array. Currently, most three-dimensional memories use a conventional matrix-arranged transistor array shown in FIG. 1, and a transistor 1 is formed by a conventional planar transistor. When a feature length of photoetching is F, a horizontal projection area (an area in a dashed box in FIG. 1) of a single transistor 1 may reach 6F² (3F×2F). However, a horizontal projection area of a memory cell in a memory array is generally 4F². Therefore, the transistor array restricts a memory cell density of the three-dimensional memory array. In recent years, a transistor with a horizontal projection area of 4F² (2F×2F) is studied in related technologies, and an average horizontal projection area of each memory cell in a memory array can be finally implemented as 4F². However, requirements for large-capacity memories still cannot be met.

Therefore, embodiments of this application provide a memory and an electronic device, so that a storage density of a memory array can be further improved by designing and optimizing a transistor array, to increase a storage capacity.

The memory may be used in various data information storage fields, for example, may be used in an electronic device such as a processor, a computer, or a server. Certainly, the memory in this embodiment of this application may also be used in another electronic device. This is not limited herein.

To make objectives, technical solutions, and advantages of this application clearer, the following further describes this application in detail with reference to the accompanying drawings.

Terms used in the following embodiments are merely intended to describe specific embodiments, but are not intended to limit this application. The terms "one", "a", "the", "the foregoing", "this", and "the one" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "comprise", "include", "have", and their variants all mean "include but are not limited to", unless otherwise especially emphasized in another manner.

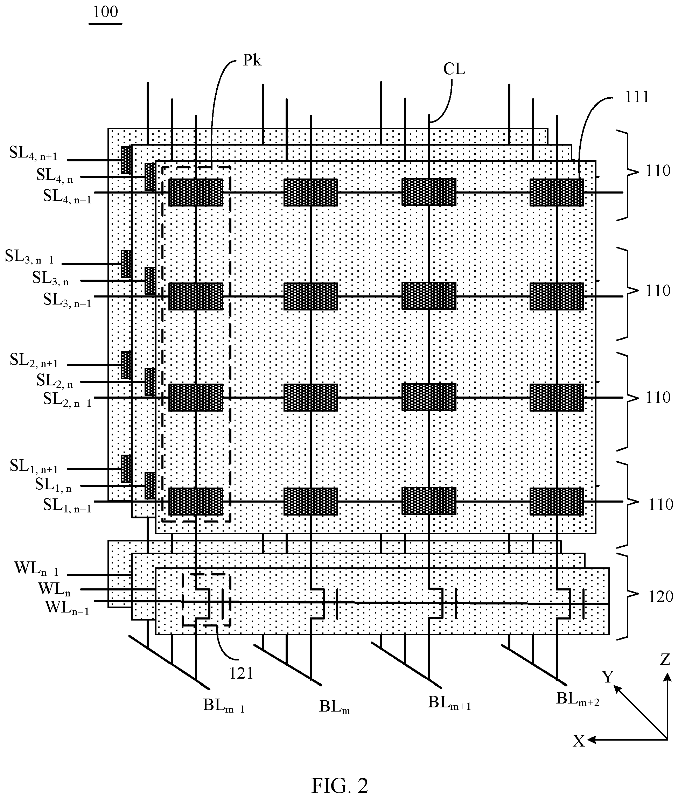

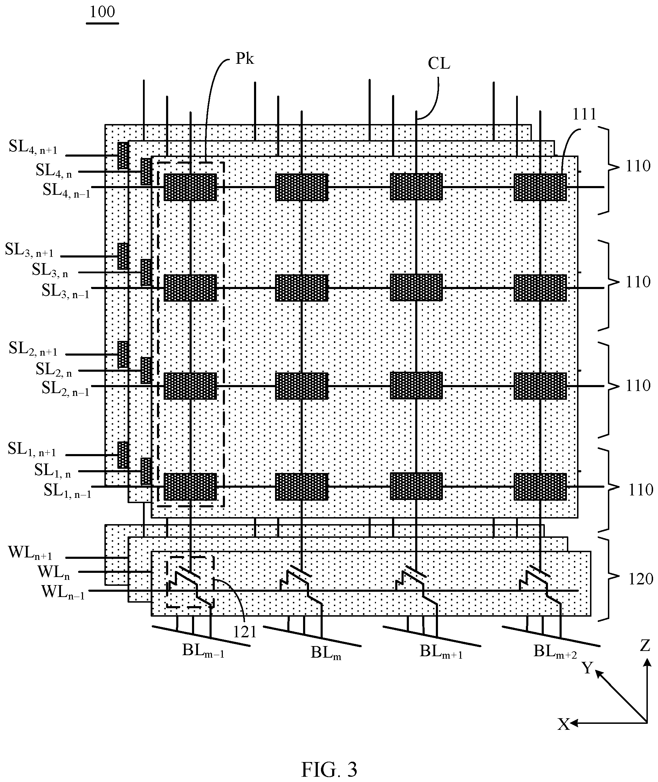

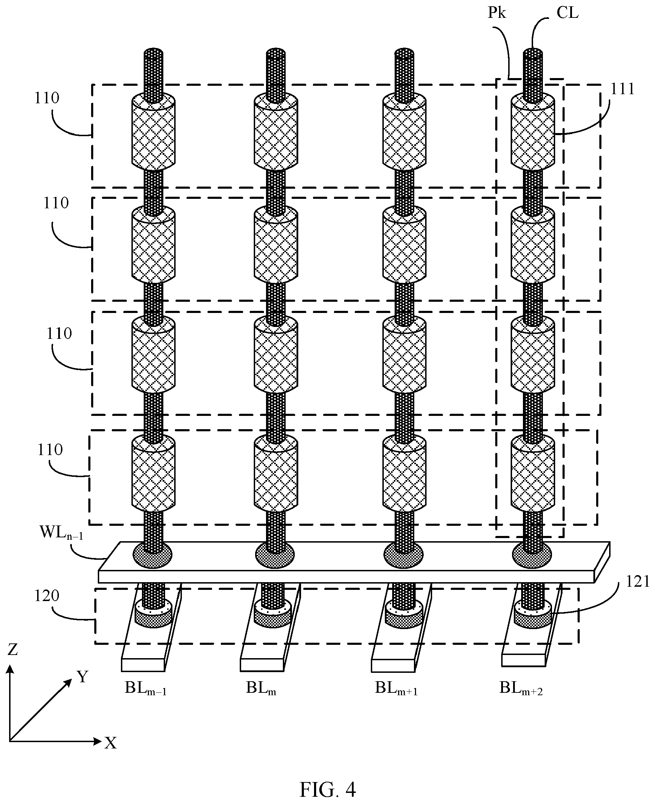

FIG. 2 is a diagram of an example of a structural framework of a memory according to an embodiment of this application. FIG. 3 is a diagram of an example of a structural framework of another memory according to an embodiment of this application. FIG. 4 is a diagram of an example of a partial structure of a memory according to an embodiment of this application. In the accompanying drawings, an X direction, a Y direction, and a Z direction are three directions that are perpendicular to each other. The memory 100 may include at least one layer of memory array 110 and a transistor array 120 disposed in a stacked manner with the at least one layer of memory array 110. The memory array 110 may be located in a plane formed by the X direction and the Y direction, and the memory array 110 and the transistor array 120 are stacked in the Z direction. A quantity of layers of memory arrays 110 is not limited in this application, for example, one layer of memory array 110, two layers of memory arrays 110, three layers of memory arrays 110, or more layers of memory arrays 110. A plurality of layers of memory arrays 110 are disposed in a stacked manner in the Z direction. In FIG. 2, four layers of memory arrays 110 are used as an example for illustration.

Still refer to FIG. 2 to FIG. 4. In this application, each layer of memory array 110 includes a plurality of memory cells 111. In an embodiment, when the memory 100 includes the plurality of layers of memory arrays 110, the memory cells 111 in each layer of memory array 110 are arranged in a same manner. In this application, memory cells 111 located at a same position in different memory arrays 110 may be referred to as a memory cell string Pk, and a quantity of memory cells 111 in each memory cell string Pk is the same as the quantity of layers of memory arrays 110 in the memory 100. In FIG. 2 to FIG. 4, an example in which each memory cell string Pk includes four memory cells 111 is used for illustration.

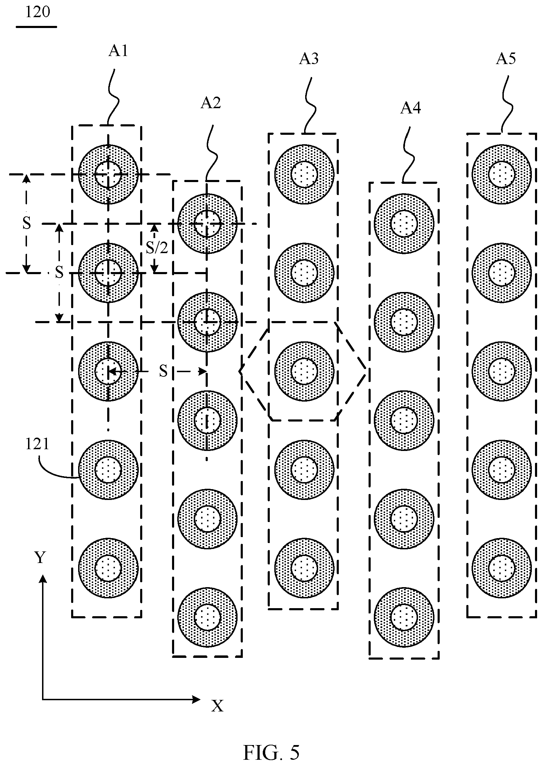

FIG. 5 is a diagram of an example of an arrangement of a transistor array according to an embodiment of this application. The transistor array 120 may include a plurality of transistor groups A1 to AM (M=5 is used as an example for illustration in FIG. 5) arranged in a first direction X. Each transistor group Am (m is any integer in 1 to M) includes a plurality of transistors 121 arranged at an equal distance in a second direction Y, where the "equal distance" means that a distance S between centers of any two adjacent transistors 121 in the transistor group Am is equal. Transistors 121 in adjacent transistor groups Am and Am+1 are arranged in a staggered manner in the second direction Y In this way, in the transistor array 120, the transistors 121 are arranged in a cellular manner. In comparison with a regular matrix arrangement of the transistor array 120, this can increase a quantity of transistors per unit area, to reduce a horizontal projection area of a single transistor, improve a density of the memory cells in the memory array, and increase a storage capacity of the memory.

For example, a distance at which transistors 121 at corresponding positions in the adjacent transistor groups Am and Am+1 are staggered in the second direction Y is equal to half of a distance between centers of two adjacent transistors 121 in the same transistor group Am. For example, the distance between the centers of any two adjacent transistors 121 in the transistor group Am is S. For the adjacent transistor groups Am and Am+1, a distance at which transistors 121 at corresponding positions in the second direction Y are staggered in the second direction Y is equal to S/2. In other words, a distance that is in the second direction Y and that is between a center of an n^{th} transistor 121 in the second direction Y in the transistor group Am and a center of an n^{th} transistor 121 in the second direction Y in the transistor group Am+1 is equal to S/2.

For example, still refer to FIG. 5. In the transistor array 120, in the adjacent transistor groups Am and Am+1, a distance between centers of the transistors 121 belonging to different transistor groups in the first direction X is equal to the distance S between the centers of the two adjacent transistors 121 in the same transistor group Am. In this way, in this application, if the distance S between the centers of any two adjacent transistors 121 is equal to 2F, the horizontal projection area (that is, a dashed box in a hexagon in the figure) of the single transistor 121 may reach about 3.46F². Therefore, in comparison with a related technology in which the horizontal projection area of the single transistor 121 is 4F², this can reduce the horizontal projection area of the single transistor 121 in the transistor array 120, improve the density of the memory cells in the memory array, and increase the storage capacity of the memory.

It should be noted that, in embodiments of this application, a concept of the "equal distance" is not completely equal in a strict sense. In a memory preparation process, due to impact of a preparation process and a preparation device, there may be a case in which distances are not strictly completely equal. This case is caused by a specific preparation process, and it cannot be indicated that the case in which the distances are not strictly completely equal goes beyond the protection scope of this application.

Still refer to FIG. 2 and FIG. 3. In this application, each transistor 121 is corresponding electrically connected to one memory cell 111 in each memory array 110. In other words, each transistor 121 controls one memory cell string Pk. Each layer of memory array 110 corresponds to a plurality of selection signal lines SL_{k, n}, and the memory 100 may further include a plurality of first control lines BLₘ and a plurality of second control lines WLₙ that correspond to the transistor array 120. Each selection signal line SL_{k, n} is electrically connected to at least one memory cell 111 in the memory array 110, each transistor 121 is electrically connected to one first control line BLₘ and one second control line WLₙ, and at least one of second control lines WLₙ and first control lines BLₘ that are electrically connected to any two transistors 121 is different. For example, any two transistors 121 are electrically connected to a same first control line BLₘ, but are electrically connected to different second control lines WLₙ; any two transistors 121 are electrically connected to a same second control line WLₙ, but are electrically connected to different first control lines BLₘ; or any two transistors 121 are electrically connected to different second control lines WLₙ, and are electrically connected to different first control lines BLₘ. In this way, one transistor 121 may be selected based on the first control line BLₘ and the second control line WLₙ, to select one memory cell string Pk electrically connected to the transistor 121, and then a single memory cell 111 in the memory cell string Pk is selected based on the selection signal line SL_{k, n}.

During specific implementation, in this application, the first control line may be a word line, and the second control line may be a bit line. Alternatively, the first control line is a bit line, and the second control line is a word line. This is not limited herein. An example in which the first control line is the bit line and the second control line is the word line is used in the accompanying drawings of this application for illustration.

For example, in this application, for the plurality of selection signal lines corresponding to each layer of memory array, for ease of cabling, as shown in FIG. 2 and FIG. 3, the plurality of selection signal lines SL_{k, n} may be arranged in the second direction Y, and each selection signal line SL_{k, n} extends in the first direction X. Certainly, during specific implementation, the plurality of selection signal lines may alternatively be arranged in the first direction X, and each selection signal line SL_{k, n} extends in the second direction Y This is not limited herein.

During specific implementation, in this application, for the plurality of selection signal lines corresponding to each layer of memory array, the plurality of selection signal lines may be disposed in parallel. For selection signal lines corresponding to different memory arrays, the selection signal lines corresponding to the different memory arrays may be disposed in parallel, or may be disposed vertically. This is not limited herein.

It should be noted that, in embodiments of this application, a concept of the "parallel" is not completely equal in a strict sense. In the memory preparation process, due to the impact of the preparation process and the preparation device, there may be a case in which selection signal lines are not strictly parallel. This case is caused by the specific preparation process, and it cannot be indicated that the case in which the selection signal lines are not strictly parallel goes beyond the protection scope of this application. In addition, similar understanding is also provided for position relationships such as "perpendicular" and "an included angle is a specific angle". Details are not described herein again.

Further, in this application, the plurality of selection signal lines corresponding to each layer of memory array may be interconnected. In this way, the plurality of selection signal lines corresponding to each layer of memory array may be electrically connected to a peripheral circuit through one cable. In other words, in this application, for each layer of memory array, only one cable is needed to implement interconnection to the peripheral circuit, so that a quantity of cables can be reduced, and an occupied area of the memory can be reduced.

It may be understood that the transistor 121 usually includes a gate electrode, a source electrode, and a drain electrode. When the gate electrode controls the transistor to be conducted, the source electrode and the drain electrode are conducted, and the source electrode and the drain electrode may be interchanged. Among the three electrodes of the transistor 121, one electrode is electrically connected to the memory cell string Pk, the 2^{nd} electrode is electrically connected to the first control line BLₘ, and the last electrode is electrically connected to the second control line WLₙ. For example, refer to FIG. 2. The gate electrode of the transistor 121 is electrically connected to the second control line WLₙ, the source electrode or the drain electrode of the transistor 121 is electrically connected to the first control line BLₘ, and the drain electrode or the source electrode of the transistor 121 is electrically connected to the memory cell string Pk. Alternatively, refer to FIG. 3. The gate electrode of the transistor 121 is electrically connected to the memory cell string Pk, the source electrode or the drain electrode of the transistor 121 is electrically connected to the first control line BLₘ, and the drain electrode or the source electrode of the transistor 121 is electrically connected to the second control line WLₙ.

Still refer to FIG. 2 to FIG. 4. In this application, a memory cell 111 in a same memory cell string Pk may be electrically connected to the transistor 121 through a common electrode CL, and each memory cell 111 has two connection ends. One end is electrically connected to the common electrode CL, and the other end is electrically connected to the selection signal line SL_{k, n}.

It should be noted that a structure of the memory cell is not limited in this application. For example, the memory cell may be a dynamic storage structure, a floating gate storage structure, a ferroelectric storage structure, a resistive storage structure, a phase change storage structure, a magnetic storage structure, or an electrochemical storage structure.

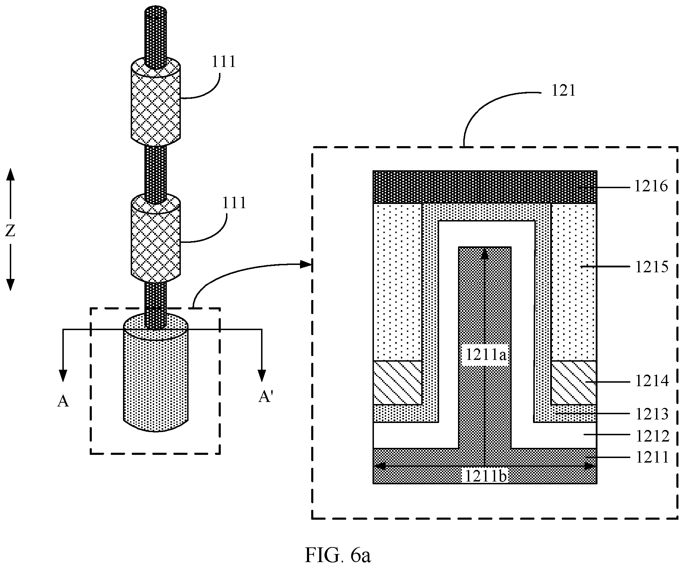

FIG. 6a to FIG. 7b are respectively diagrams of examples of cross-sectional structures of a transistor in an AA' direction according to embodiments of this application. As shown in FIG. 6a to FIG. 7b, the transistor 121 may include a gate electrode 1211, a gate oxygen medium 1212, a semiconductor channel material 1213, a first electrode 1214, an insulation medium 1215, and a second electrode 1216. It should be noted that, in this application, the first electrode 1214 is a source electrode, and the second electrode 1216 is a drain electrode. Alternatively, the first electrode 1214 is a drain electrode, and the second electrode 1216 is a source electrode.

Still refer to FIG. 6a to FIG. 7b. In this application, the gate electrode 1211 includes a columnar portion 1211a extending in a stacking direction Z of the memory and a planar portion 1211b located at one end of the columnar portion 1211a. The gate oxygen medium 1212 and the semiconductor channel material 1213 sequentially wrap an outer side of the columnar portion 1211a. The first electrode 1214 surrounds or partially surrounds the semiconductor channel material 1213, and the first electrode 1214 is located near the planar portion 1211b. The second electrode 1216 is located at one end of the columnar portion 1211a away from the planar portion 1211b, and the second electrode 1216 and the columnar portion 1211a are spaced by the gate oxygen medium 1212 and the semiconductor channel material 1213. The insulation medium 1215 is disposed between the first electrode 1214 and the second electrode 1216, to electrically isolate the first electrode 1214 from the second electrode 1216.

In this application, two ends of the transistor in the Z direction are respectively the gate electrode 1211 and the second electrode 1216. Therefore, the memory array may be stacked on one end of the gate electrode 1211 of the transistor 121 and directly electrically connected to the gate electrode 1211, or may be stacked on one end of the second electrode 1216 of the transistor 121 and directly electrically connected to the second electrode 1216. In this way, no additional area needs to be added for interconnection between the memory array and the transistor, and flexibility of the interconnection between the transistor and the memory array can be improved. This is applicable to high-density storage devices with different readout manners.

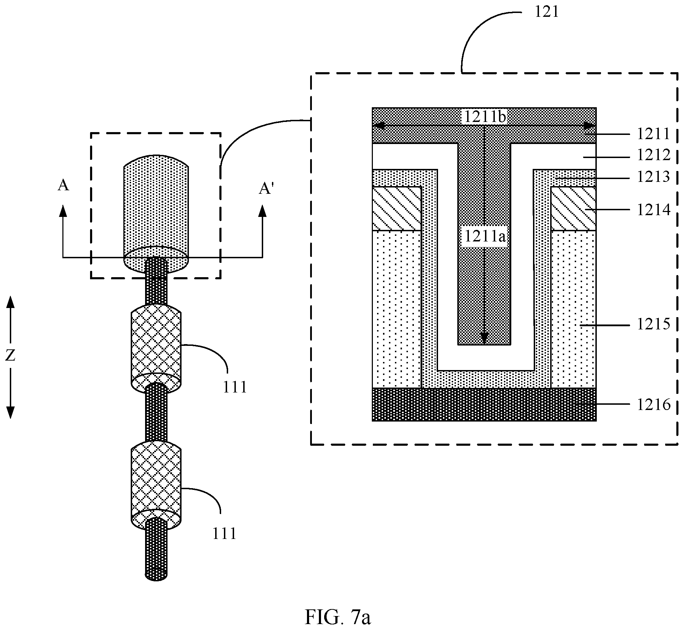

During specific implementation, refer to FIG. 6a and FIG. 7a. With reference to FIG. 2, the memory array 110 may be located on one side of the second electrode 1216 of the transistor 121, and the second electrode 1216 of the transistor 121 is electrically connected to a corresponding memory cell 111. For example, the first electrode 1214 of the transistor 121 may be electrically connected to the first control line BLₘ, and the gate electrode 1211 of the transistor 121 may be electrically connected to the second control line WLₙ. Alternatively, the first electrode 1214 of the transistor 121 may be electrically connected to the second control line WLₙ, and the gate electrode 1211 of the transistor 121 may be electrically connected to the first control line BLₘ.

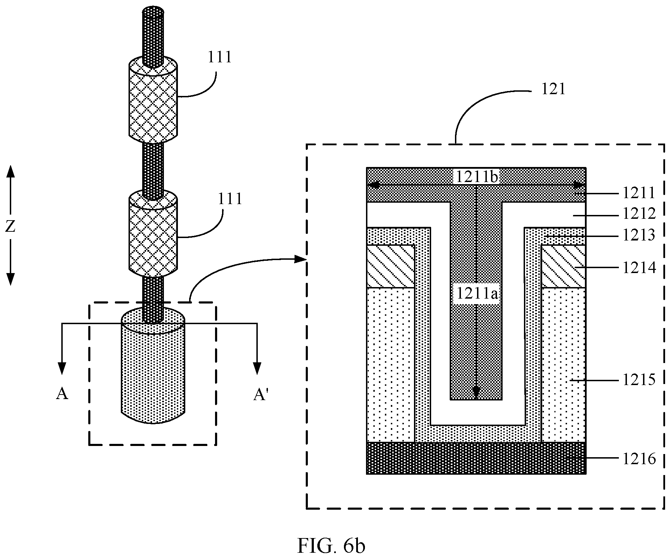

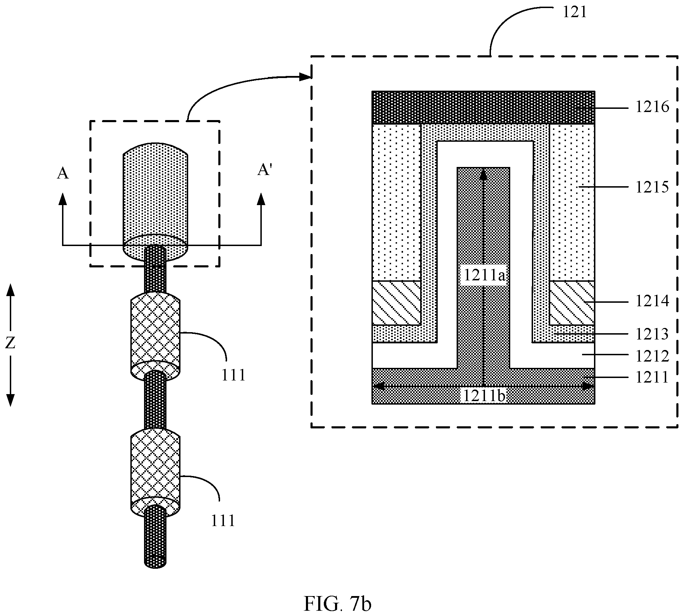

Alternatively, refer to FIG. 6b and FIG. 7b. With reference to FIG. 3, the memory array 110 may be located on one side of the gate electrode 1211 of the transistor 121, and the gate electrode 1211 of the transistor 121 is electrically connected to a corresponding memory cell 111. For example, the first electrode 1214 of the transistor 121 may be electrically connected to the second control line WLₙ, and the second electrode 1216 of the transistor 121 may be electrically connected to the first control line BLₘ. Alternatively, the first electrode 1214 of the transistor 121 may be electrically connected to the first control line BLₘ, and the second electrode 1216 of the transistor 121 may be electrically connected to the second control line WLₙ.

Further, a stacking direction of the memory array is not limited in this application. As shown in FIG. 6a and FIG. 6b, the memory array may be stacked above the transistor array. In other words, the memory cell 111 is located above the transistor 121. Alternatively, as shown in FIG. 7a and FIG. 7b, the transistor array is stacked above the memory array. In other words, the transistor 121 is located above the memory cell 111.

In the transistor 121, the first electrode 1214 and the second electrode 1216 may be formed by using a conductive material, and the conductive material includes TiN, Ru, Ag, Ti, Au, W, Al, Cu, Mo, In-Ti-O (ITO), or the like, or any combination thereof. The gate oxygen medium 1212 may be formed by using an insulation material, and the insulation material includes SiO₂, HfO₂, ZrO₂, Al₂O₃, TiO₂, Si₃N₄, Y₂O₃, or the like, or any combination thereof. The semiconductor channel material 1213 may be a semiconductor material like Si, MoS₂, poly-Si, ZnO, amorphous-Si, ITO, In-Ga-Zn-O (IGZO), or TiO₂, or any combination thereof. The insulation medium 1215 may be formed by using an insulation material like SiO₂, Si₃N₄, or Al₂O₃. This is not limited herein.

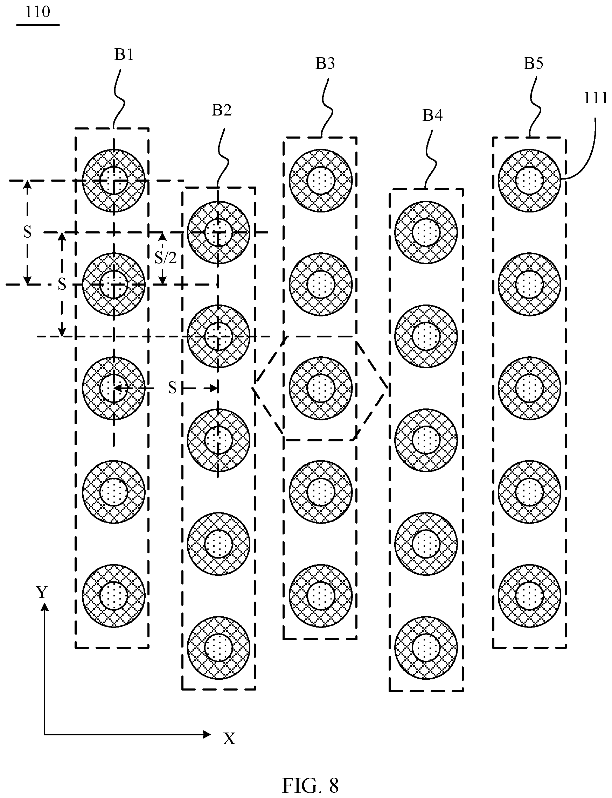

It may be understood that, in this application, each transistor is electrically connected to one memory cell string, an arrangement manner of all memory cell strings is the same as an arrangement manner of the transistor array, and the memory cell string is stacked above or below a corresponding transistor. In other words, an arrangement manner of each layer of memory array is the same as the arrangement manner of the transistor array. For example, as shown in FIG. 8, each memory array 110 may include a plurality of memory cell groups B1 to BM (M=5 is used as an example for illustration in FIG. 8) arranged in the first direction X. Each memory cell group Bm (m is any integer in 1 to M) includes a plurality of memory cells 111 arranged in the second direction Y, a distance S between centers of any two adjacent memory cells 111 is equal, and the distance S between the centers of any two adjacent memory cells 111 is equal to the distance between the centers of the two adjacent transistors in the same transistor group. Memory cells 111 in adjacent memory cell groups Bm and Bm+1 are arranged in a staggered manner in the second direction Y For the adjacent memory cell groups Bm and Bm+1, a distance at which memory cells 111 at a same position in the second direction Y are staggered in the second direction Y is equal to S/2. For example, a distance that is in the second direction Y and that is between a center of an n^{th} memory cell 111 in the memory cell group Bm in the second direction Y and a center of an n^{th} memory cell 111 in the memory cell group Bm+1 in the second direction Y is equal to S/2. In other words, in the memory array 110, the memory cells 111 are arranged in a cellular manner, and a horizontal projection area of the memory cell 111 at least partially overlaps the horizontal projection area of the transistor 121 electrically connected to the memory cell 111. In FIG. 8, one layer of memory array 110 is used as an example for illustration.

For example, in the transistor array 120, in the adjacent transistor groups Am and Am+1, when the distance between the centers of the transistors 121 belonging to the different transistor groups in the first direction X is equal to the distance S between the centers of the two adjacent transistors 121 in the same transistor group Am, referring to FIG. 8, in the memory array 110, in the adjacent memory cell groups Bm and Bm+1, a distance between centers of the memory cells 111 belonging to different memory cell groups in the first direction X is equal to a distance S between centers of two adjacent memory cells 111 in the same memory cell group Bm.

It can be learned from the foregoing that, in this application, because the transistors in the transistor array are arranged in the cellular manner, memory cells in a corresponding memory array are arranged in the cellular manner. In comparison with the regular matrix arrangement of the transistor array, this can increase the quantity of transistors per unit area, to reduce the horizontal projection area of the single transistor, improve the density of the memory cells in the memory array, and increase the storage capacity of the memory.

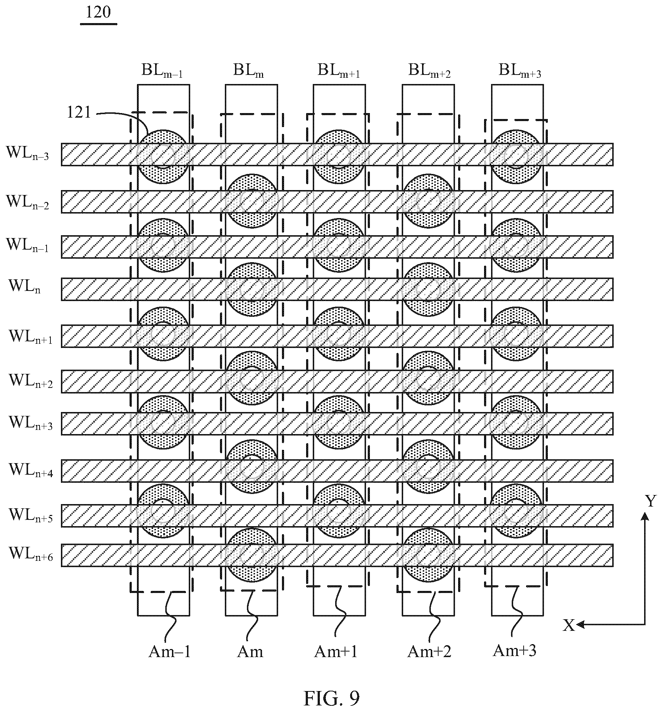

Further, in this application, for the first control line and the second control line that are correspondingly electrically connected to the transistor array, to facilitate cabling and reduce difficulty in peripheral circuit design, refer to FIG. 9 to FIG. 12. The plurality of first control lines BLₘ are arranged in the first direction X, each first control line BLₘ extends in the second direction Y, and each first control line BLₘ is correspondingly electrically connected to one transistor group Am. For example, in this application, the plurality of first control lines BLₘ may be disposed in parallel.

For an arrangement of the second control line, in this application, refer to FIG. 9 to FIG. 11. The plurality of second control lines WLₙ are arranged in the second direction Y, and each second control line WLₙ extends in the first direction X. Each transistor 121 in the transistor group Am corresponds to one second control line WLₙ, transistor groups Am (m=1, 3, 5, 7, ...) located at odd-numbered positions in the first direction X share a second control line WLₙ, and transistor groups Am (m=2, 4, 6, 8, ...) located at even-numbered positions in the first direction X share a second control line WLₙ.

In an embodiment, refer to FIG. 9. The second control line WLₙ is in a straight line shape, and each transistor group Am (m=1, 3, 5, 7, ...) located at the odd-numbered position in the first direction X and each transistor group Am (m=2, 4, 6, 8, ...) located at the even-numbered position in the first direction X are electrically connected to different second control lines WLₙ. In other words, the adjacent transistor groups Am and Am+1 do not share a second control line WLₙ.

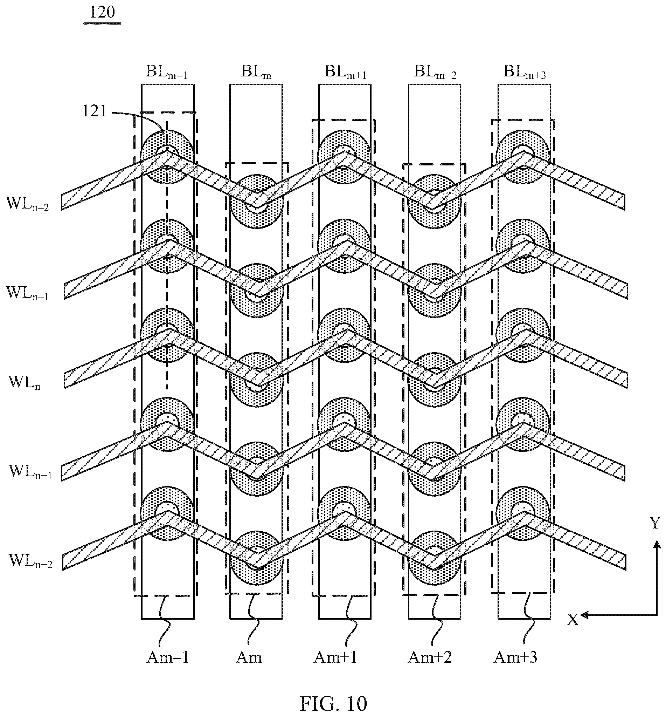

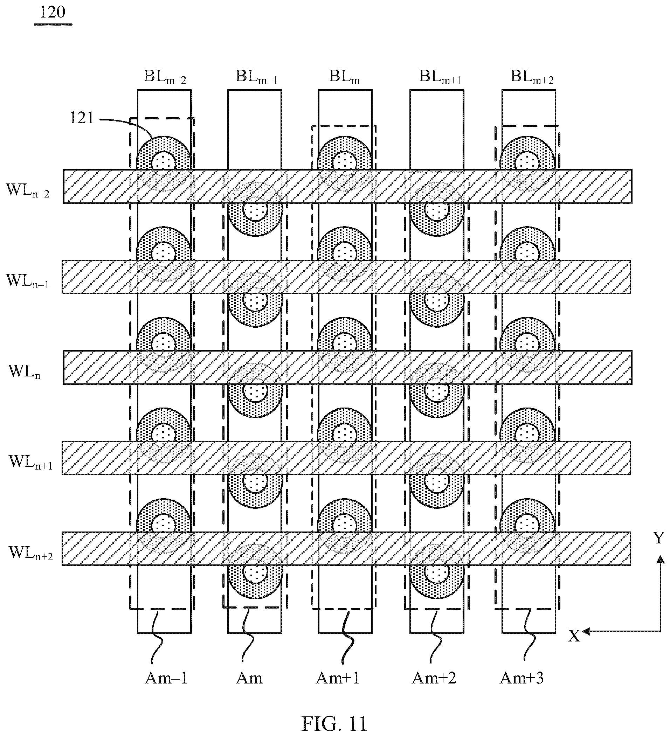

Further, to increase a distance between adjacent second control lines, to reduce impact of parasitic capacitance, a quantity of second control lines may be reduced. For example, each transistor group Am (m=1, 3, 5, 7, ...) located at the odd-numbered position in the first direction X may be enabled to share the second control line WLₙ with each transistor group Am located at the even-numbered position in the first direction X. For example, as shown in FIG. 10 and FIG. 11, two adjacent rows of transistors 121 in the second direction Y share a second control line WLₙ. For example, in FIG. 10, each transistor group Am has five transistors 121. Transistors in the transistor group Am (m=1, 3, 5, 7, ...) located at the odd-numbered position in the first direction X and transistors in the transistor group Am (m=2, 4, 6, 8, ...) located at the even-numbered position are disposed in a staggered manner. In this case, the transistor array has 10 rows of transistors. In two adjacent rows of transistors 121 in the second direction Y, one row of transistors 121 belongs to the transistor group Am (m=1, 3, 5, 7, ...) located at the odd-numbered position, and the other row of transistors 121 belongs to the transistor group Am (m=2, 4, 6, 8, ...) located at the even-numbered position.

For example, when the two adjacent rows of transistors 121 in the second direction Y share the second control line WLₙ, in a feasible implementation, refer to FIG. 10. The second control line WLₙ is in a sawtooth shape. It should be noted that the "sawtooth shape" herein may be an "S" shape. This is not limited herein. Alternatively, in another feasible implementation, refer to FIG. 11. The second control line WLₙ is in the straight line shape. In comparison with the sawtooth-shaped second control line WLₙ, the straight-line-shaped second control line WLₙ can reduce preparation difficulty.

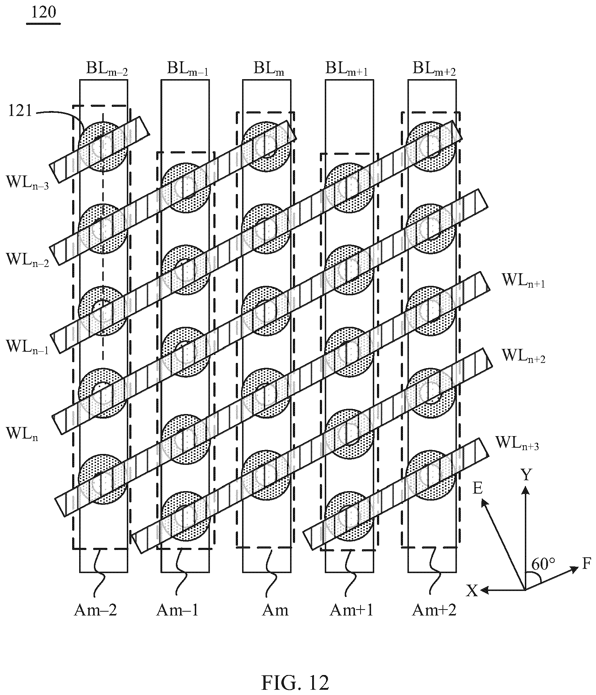

In this application, to increase a distance between adjacent second control lines, in another embodiment, refer to FIG. 12. The plurality of second control lines WLₙ may be arranged in a third direction E, and each second control line WLₙ extends in a fourth direction F. An included angle between the fourth direction F and the second direction Y is 60 degrees, and the third direction E is perpendicular to the fourth direction F. Each transistor 121 in the transistor group Am corresponds to one second control line WLₙ, and each transistor group Am (m=1, 3, 5, 7, ...) located at an odd-numbered position in the first direction X and each transistor group Am (m=2, 4, 6, 8, ...) located at an even-numbered position in the first direction X share at least a part of the second control line WLₙ.

Optionally, in this application, still refer to FIG. 9 to FIG. 12. The second control lines WLₙ may be disposed in parallel. In this way, it can be ensured that the distance between the adjacent second control lines is equal everywhere, and preparation difficulty can be reduced.

It should be noted that, in this application, for the transistor array 120 shown in FIG. 9 to FIG. 12, the gate electrode of the transistor 121 may be electrically connected to the second control line WLₙ, the source electrode or the drain electrode of the transistor 121 is electrically connected to the first control line BLₘ, and the drain electrode or the source electrode of the transistor 121 is electrically connected to the memory cell 111. Alternatively, the gate electrode of the transistor 121 is electrically connected to the memory cell 111, the source electrode or the drain electrode of the transistor 121 is electrically connected to the first control line BLₘ, and the drain electrode or the source electrode of the transistor 121 is electrically connected to the second control line WLₙ.

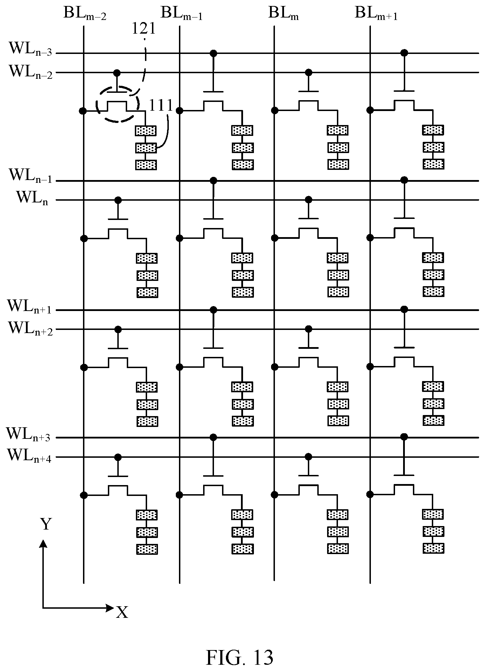

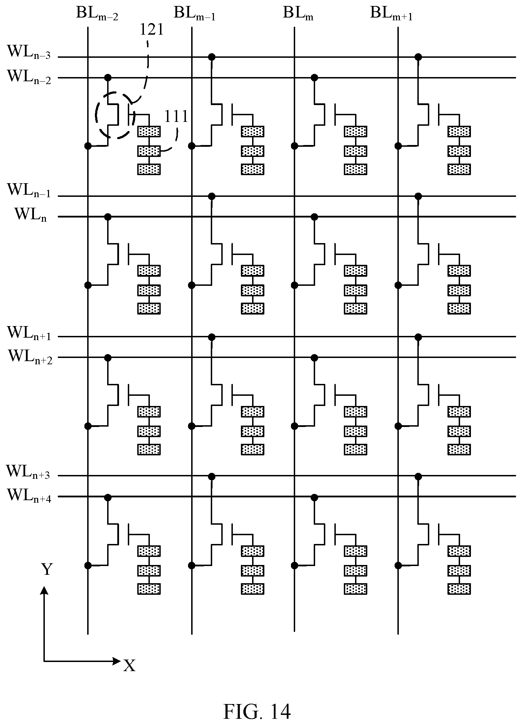

For example, the transistor array 120 shown in FIG. 9 is used as an example. The plurality of first control lines BLₘ are arranged in the first direction X, and each first control line BLₘ extends in the second direction Y The plurality of second control lines WLₙ are arranged in the second direction Y, and each second control line WLₙ extends in the first direction X. Each transistor 121 in the transistor group Am corresponds to one second control line WLₙ, transistor groups Am (m=1, 3, 5, 7, ...) located at the odd-numbered positions in the first direction X share a second control line WLₙ, and transistor groups Am (m=2, 4, 6, 8, ...) located at the even-numbered positions in the first direction X share a second control line WLₙ. Each transistor group Am (m=1, 3, 5, 7, ...) located at the odd-numbered position in the first direction X and each transistor group Am (m=2, 4, 6, 8, ...) located at the even-numbered position in the first direction X are electrically connected to different second control lines WLₙ. In other words, the adjacent transistor groups Am and Am+1 do not share a second control line WLₙ. In an embodiment, as shown in FIG. 13, the gate electrode of the transistor 121 is electrically connected to the second control line WLₙ, the source electrode or the drain electrode of the transistor 121 is electrically connected to the first control line BLₘ, and the drain electrode or the source electrode of the transistor 121 is electrically connected to the memory cell 111. In another embodiment, as shown in FIG. 14, the gate electrode of the transistor 121 is electrically connected to the memory cell 111, the source electrode or the drain electrode of the transistor 121 is electrically connected to the first control line BLₘ, and the drain electrode or the source electrode of the transistor 121 is electrically connected to the second control line WLₙ.

Based on a same technical idea, the cellularly arranged transistor array provided in the example of this application may be used in a 2T0C memory. In the memory, each layer of memory array is formed by stacking two layers of transistor arrays. A single memory cell in the memory array includes two transistors. A second electrode of one transistor is connected to a gate electrode of the other transistor, and the memory cell may store information by using a capacitor of a connection node of the two transistors.

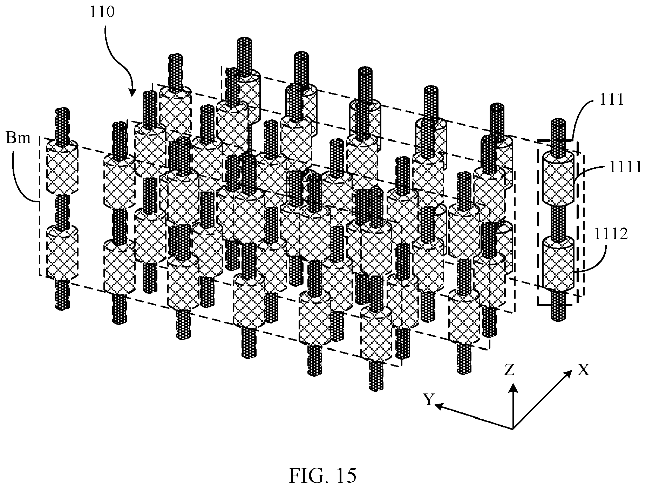

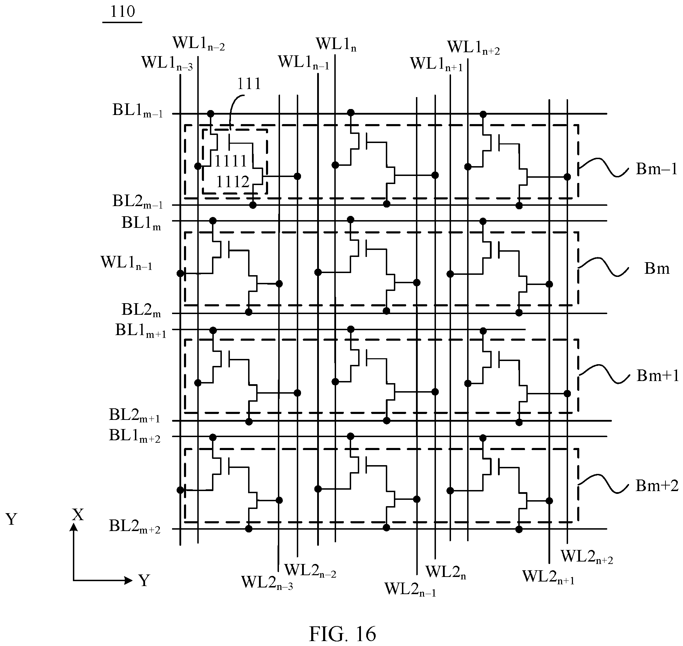

Refer to FIG. 15 and FIG. 16. In this application, a memory may include at least one layer of memory array 110. Each memory array 110 in the at least one layer of memory array 110 corresponds to a plurality of first control lines BL1ₘ, a plurality of second control lines WL1ₙ, a plurality of third control lines BL2ₘ, and a plurality of fourth control lines WL2ₙ. In both FIG. 15 and FIG. 16, an example in which the memory includes one layer of memory array is used for illustration.

In the memory, for arrangement of memory cells in each memory array, refer to the arrangement of the memory array shown in FIG. 8. Each memory array 110 includes a plurality of memory cell groups Bm arranged in a first direction X. Each memory cell group Bm includes a plurality of memory cells 111 arranged in a second direction Y, distances between centers of any two adjacent memory cells 111 in the plurality of memory cell groups Bm are equal, memory cells 111 in adjacent memory cell groups Bm are arranged in a staggered manner in the second direction Y, and the first direction X is perpendicular to the second direction Y In other words, in the memory array 110, the memory cells 111 are arranged in a cellular manner.

Still refer to FIG. 15 and FIG. 16. In this application, each memory cell 111 includes a first transistor 1111 and a second transistor 1112 that are disposed in a stacked manner in a Z direction, and a gate electrode of the first transistor 1111 is electrically connected to a source electrode or a drain electrode of the second transistor 1112. A source electrode and a drain electrode of each first transistor 1111 are electrically connected to one first control line BL1ₘ and one second control line WL1ₙ respectively, and at least one control line of first control lines BL1ₘ and second control lines WL1ₙ that are electrically connected to any two first transistors 1111 is different. A gate electrode and a drain electrode or a source electrode of each second transistor 1112 are electrically connected to one third control line BL2ₘ and one fourth control line WL2ₙ respectively, and at least one control line of third control lines BL2ₘ and fourth control lines WL2ₙ that are electrically connected to any two second transistors 1112 is different.

In this application, each memory array is formed by two layers of transistor arrays. One layer of transistor array is formed by first transistors arranged in the cellular manner, and the other layer of transistor array is formed by second transistors arranged in the cellular manner. A memory array is formed by using two layers of transistor arrays. Each memory cell in the memory array corresponds to one first control line BL1ₘ, one second control line WL1ₙ, one third control line BL2ₘ, and one fourth control line WL2ₙ. Therefore, each layer of memory array can implement site selection by using the first control line BL1ₘ, the second control line WL1ₙ, the third control line BL2ₘ, and the fourth control line WL2ₙ, and no additional transistor array needs to be disposed for a stacked memory array. Therefore, in the memory, a storage density of the memory array may be determined based on a horizontal projection area of a single memory cell in the memory array. In the memory, memory cells in the memory array are arranged in the cellular manner. Therefore, in comparison with a regular matrix arrangement, this can increase a quantity of memory cells per unit area, to reduce a horizontal projection area of a single memory cell, improve a density of memory cells in the memory array, and increase a storage capacity of the memory.

For example, still refer to FIG. 8. In the memory array 110, a distance at which memory cells 111 at corresponding positions in adjacent memory cell groups Bm and Bm+1 are staggered in the second direction Y is equal to half of a distance between centers of two adjacent memory cells 111 in a same memory cell group Bm. For example, a distance between centers of any two adjacent memory cells 111 in the memory cell group Bm is S. For the adjacent memory cell groups Bm and Bm+1, a distance at which memory cells 111 at corresponding positions in the second direction Y are staggered in the second direction Y is equal to S/2. In other words, a distance that is in the second direction Y and that is between a center of an n^{th} memory cell 111 in the memory cell group Bm in the second direction Y and a center of an n^{th} memory cell 111 in the memory cell group Bm+1 in the second direction Y is equal to S/2.

Further, in the adjacent memory cell group Bm, a distance between centers of the memory cells 111 belonging to different memory cell groups Bm in the first direction X is equal to the distance between centers of two adjacent memory cells 111 in a same memory cell group Bm. In this way, in this application, if a distance S between centers of any two adjacent memory cells 111 (that is, any two adjacent first transistors 1111 and any two adjacent second transistors 1112) is equal to 2F, a horizontal projection area of a single memory cell 111 may reach about 3.46F². Therefore, in comparison with a related technology in which a horizontal projection area of a single memory cell is 4F², this can reduce the horizontal projection area of the single memory cell 111, improve the density of memory cells in the memory array, and increase the storage capacity of the memory.

During specific implementation, in this application, one of the first control line and the second control line that are interconnected to the first transistor may be a bit line, and the other may be a word line. This is not limited herein. Similarly, one of the third control line and the fourth control line that are interconnected to the second transistor may be a bit line, and the other may be a word line. This is not limited herein.

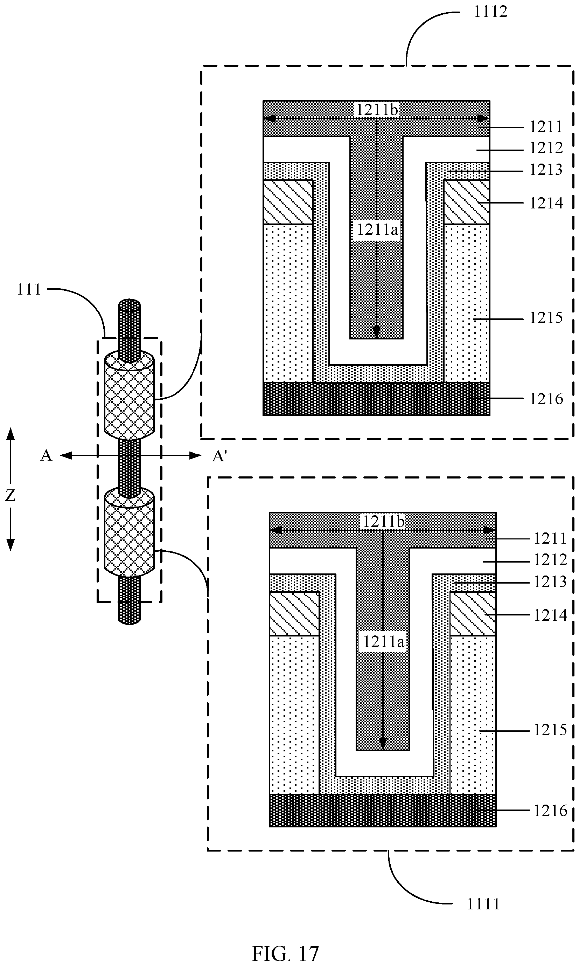

FIG. 17 is a diagram of a cross-sectional structure of a transistor in an AA' direction according to an embodiment of this application. In the memory, both a first transistor 1111 and a second transistor 1112 include a gate electrode 1211, a gate oxygen medium 1212, a semiconductor channel material 1213, a first electrode 1214, an insulation medium 1215, and a second electrode 1216. The gate electrode 1211 includes a columnar portion 1211a extending in a stacking direction Z of the memory and a planar portion 1211b located at one end of the columnar portion 1211a. The gate oxygen medium 1212 and the semiconductor channel material 1213 sequentially wrap an outer side of the columnar portion 1211a. The first electrode 1214 surrounds or partially surrounds the semiconductor channel material 1213, and the first electrode 1214 is located near the planar portion 1211b. The second electrode 1216 is located at one end of the columnar portion 1211a away from the planar portion 1211b, and the second electrode 1216 and the columnar portion 1211a are spaced by the gate oxygen medium 1212 and the semiconductor channel material 1213. The insulation medium 1215 is disposed between the first electrode 1214 and the second electrode 1216, to electrically isolate the first electrode 1214 from the second electrode 1216. The gate electrode of the first transistor 1111 is disposed facing the second electrode of the second transistor 1112, and the gate electrode of the first transistor 1111 is electrically connected to the second electrode of the second transistor 1112.

In the first transistor 1111, the first electrode 1214 is a source electrode, and the second electrode 1216 is a drain electrode. Alternatively, the first electrode 1214 is a drain electrode, and the second electrode 1216 is a source electrode. Similarly, in the second transistor 1112, the first electrode 1214 is a source electrode, and the second electrode 1216 is a drain electrode. Alternatively, the first electrode 1214 is a drain electrode, and the second electrode 1216 is a source electrode.

During specific implementation, in a memory cell, the first transistor 1111 may be stacked above the second transistor 1112, or certainly, the second transistor 1112 may be stacked above the first transistor 1111. This is not limited herein.

In this application, for the first transistor 1111 and the second transistor 1112, the first electrode 1214 and the second electrode 1216 may be formed by using a conductive material, including TiN, Ru, Ag, Ti, Au, W, Al, Cu, Mo, In-Ti-O (ITO), or the like, or any combination thereof. The gate oxygen medium 1212 may be formed by using an insulation material, including SiO₂, HfO₂, ZrO₂, Al₂O₃, TiO₂, Si₃N₄, Y₂O₃, or the like, or any combination thereof. The semiconductor channel material may be a semiconductor material like Si, MoS₂, poly-Si, ZnO, amorphous-Si, ITO, In-Ga-Zn-O (IGZO) or TiO₂, or any combination thereof. The insulation medium 1215 may be formed by using an insulation material like SiO₂, Si₃N₄, or Al₂O₃. This is not limited herein.

To facilitate cabling and reduce difficulty in peripheral circuit design, in this application, as shown in FIG. 16, in the memory array 110, the plurality of first control lines BL1ₘ may be arranged in the first direction X, each first control line BL1ₘ extends in the second direction Y, and each first control line BL1ₘ is correspondingly electrically connected to one memory cell group Bm. The plurality of third control lines BL2ₘ are arranged in the first direction X, each third control line BL2ₘ extends in the second direction Y, and each third control line BL2ₘ is correspondingly electrically connected to one memory cell group Bm.

For example, in this application, the plurality of first control lines BL1ₘ may be disposed in parallel, and the plurality of third control lines BL2ₘ may be disposed in parallel.

Still refer to FIG. 16. In this application, in the memory array 110, the plurality of second control lines WL1ₙ may be arranged in the second direction Y, and each second control line WL1ₙ extends in the first direction X. Each first transistor 1111 in the memory cell group Bm corresponds to one second control line WL1ₙ, memory cell groups Bm located at odd-numbered positions in the first direction X share the second control line WL1ₙ, and memory cell groups Bm located at even-numbered positions in the first direction X share the second control line WL1ₙ.

Still refer to FIG. 16. In this application, in the memory array 110, the plurality of fourth control lines WL2ₙ are arranged in the second direction Y, and each fourth control line WL2ₙ extends in the first direction X. Each second transistor 1112 in the memory cell group Bm corresponds to one fourth control line WL2ₙ, memory cell groups Bm located at odd-numbered positions in the first direction X share the fourth control line WL2ₙ, and memory cell groups Bm located at even-numbered positions in the first direction X share the fourth control line WL2ₙ.

In a feasible implementation, in this application, the second control line WL1ₙ is in a straight line shape, and a second control line WL1ₙ electrically connected to each memory cell group Bm located at an odd-numbered position in the first direction X is different from a second control line WL1ₙ electrically connected to each memory cell group Bm located at an even-numbered position in the first direction X. For example, for disposing of the second control line WL1ₙ, refer to the disposing of the second control line WLₙ in the embodiment shown in FIG. 9.

In a feasible implementation, in this application, the fourth control line WL2ₙ is in the straight line shape, and a fourth control line WL2ₙ electrically connected to each memory cell group Bm located at an odd-numbered position in the first direction X is different from a fourth control line WL2ₙ electrically connected to each memory cell group Bm located at an even-numbered position in the first direction X. For example, for disposing of the fourth control line WL2ₙ, refer to the disposing of the second control line WLₙ in the embodiment shown in FIG. 9.

Further, to increase a distance between adjacent second control lines, to reduce impact of parasitic capacitance, in this application, the second control line WL1ₙ is in the straight line shape or a sawtooth shape, and two adjacent rows of memory cells 111 in the second direction Y share the second control line WL1ₙ. For example, for the disposing of the second control line WL1ₙ, refer to the disposing of the second control line WLₙ in the embodiments shown in FIG. 10 and FIG. 11.

Further, to increase a distance between adjacent fourth control lines, to reduce the impact of parasitic capacitance, in this application, the fourth control line WL2ₙ is in the straight line shape or the sawtooth shape, and two adjacent rows of memory cells 111 in the second direction Y share the fourth control line WL2ₙ. For example, for the disposing of the fourth control line WL2ₙ, refer to disposing of the second control line WLₙ in the embodiments shown in FIG. 10 and FIG. 11.

In this application, to increase the distance between adjacent second control lines, in another embodiment, in the memory array 110, the plurality of second control lines WL1ₙ are arranged in a third direction E, and each second control line WL1ₙ extends in a fourth direction F. An included angle between the fourth direction F and the second direction Y is 60 degrees, and the third direction E is perpendicular to the fourth direction F. Each first transistor 1111 in the memory cell group Bm corresponds to one second control line WL1ₙ, and each memory cell group Bm located at an odd-numbered position in the first direction X and each memory cell group Bm located at an even-numbered position in the first direction X share at least a part of the second control line WL1ₙ. For example, for the disposing of the second control line WL1ₙ, refer to the disposing of the second control line WLₙ in the embodiment shown in FIG. 12.

In this application, to increase the distance between adjacent second control lines, in another embodiment, in the memory array 110, the plurality of fourth control lines WL2ₙ are arranged in the third direction E, and each fourth control line WL2ₙ extends in the fourth direction F. The included angle between the fourth direction F and the second direction Y is 60 degrees, and the third direction E is perpendicular to the fourth direction F. Each second transistor 1112 in the memory cell group Bm corresponds to one fourth control line WL2ₙ, and each memory cell group Bm located at an odd-numbered position in the first direction X and each memory cell group Bm located at an even-numbered position in the first direction X share at least a part of the fourth control line WL2ₙ. For example, for the disposing of the fourth control line WL2ₙ, refer to the disposing of the second control line WLₙ in the embodiment shown in FIG. 12.

Optionally, in this application, the second control lines WL1ₙ may be disposed in parallel. In this way, it can be ensured that a distance between adjacent second control lines WL1ₙ is equal everywhere, and preparation difficulty can be reduced. Correspondingly, the fourth control lines WL2ₙ may alternatively be disposed in parallel. In this way, it can be ensured that a distance between adjacent fourth control lines WL2ₙ is equal everywhere, and the preparation difficulty can be reduced.

It should be noted that, in the memory shown in FIG. 16, for disposing of the first control line BL1ₘ and the second control line WL1ₙ that are electrically connected to the first transistor 1111, refer to the disposing of the first control line BLₘ and the second control line WLₙ in the embodiments shown in FIG. 9 to FIG. 12. Similarly, for disposing of the third control line BL2ₘ and the fourth control line WL2ₙ that are electrically connected to the second transistor 1112, refer to the disposing of the first control line BLₘ and the second control line WLₙ in the embodiments shown in FIG. 9 to FIG. 12. Details are not described herein again.

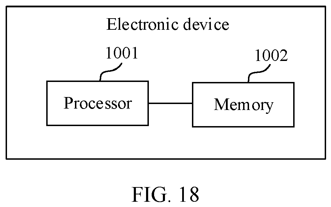

Based on a same technical idea, an embodiment of this application further provides an electronic device. Refer to FIG. 18. The electronic device includes a processor 1001 and a memory 1002 coupled to the processor 1001. The memory 1002 may be any memory provided in the foregoing embodiments of this application. Specifically, the processor 1001 may invoke a software program stored in the memory 1002 to perform a corresponding method and implement a corresponding function of the electronic device.

It is clear that a person skilled in the art can make various modifications and variations to this application without departing from the protection scope of this application. This application is intended to cover these modifications and variations of this application provided that they fall within the scope of protection defined by the following claims and their equivalent technologies.

## Claims

1. A memory, comprising:
at least one layer of memory array, wherein each layer of memory array in the at least one layer of memory array comprises a plurality of memory cells, wherein
each layer of memory array in the at least one layer of memory array corresponds to a plurality of selection signal lines, and each selection signal line is electrically connected to at least one memory cell in the memory array;
a transistor array disposed in a stacked manner with the at least one layer of memory array, wherein the transistor array comprises a plurality of transistor groups arranged in a first direction, each transistor group comprises a plurality of transistors arranged at an equal distance in a second direction, adjacent transistor groups are arranged in a staggered manner in the second direction, each transistor in the transistor group is correspondingly electrically connected to one memory cell in each layer of memory array in the at least one layer of memory array, and the first direction is perpendicular to the second direction; and
a plurality of first control lines and a plurality of second control lines, wherein each transistor is electrically connected to one first control line and one second control line, and at least one control line of first control lines and second control lines that are electrically connected to any two transistors is different.

2. The memory according to claim 1, wherein in the transistor array, a distance at which transistors at corresponding positions in the adjacent transistor groups are staggered in the second direction is equal to half of a distance between centers of two adjacent transistors in a same transistor group; and
in the adjacent transistor groups, a distance between centers that are of the transistors belonging to different transistor groups and that are in the first direction is equal to the distance between the centers of the two adjacent transistors in the same transistor group.

3. The memory according to claim 1 or 2, wherein the transistor comprises a gate electrode, a gate oxygen medium, a semiconductor channel material, a first electrode, an insulation medium, and a second electrode, wherein
the gate electrode comprises a columnar portion extending in a stacking direction of the memory and a planar portion located at one end of the columnar portion; the gate oxygen medium and the semiconductor channel material sequentially wrap an outer side of the columnar portion; the first electrode surrounds or partially surrounds the semiconductor channel material, and the first electrode is located near the planar portion; the second electrode is located at one end of the columnar portion away from the planar portion, and the second electrode and the columnar portion are spaced by the gate oxygen medium and the semiconductor channel material; and the insulation medium is disposed between the first electrode and the second electrode.

4. The memory according to claim 3, wherein the memory array is located on one side of the gate electrode of the transistor, the gate electrode of the transistor is electrically connected to a corresponding memory cell, the first electrode of the transistor is electrically connected to the second control line, and the second electrode of the transistor is electrically connected to the first control line; or
the memory array is located on one side of the second electrode of the transistor, the second electrode of the transistor is electrically connected to a corresponding memory cell, the first electrode of the transistor is electrically connected to the first control line, and the gate electrode of the transistor is electrically connected to the second control line.

5. The memory according to claim 4, wherein the plurality of first control lines are arranged in the first direction, each first control line extends in the second direction, and each first control line is correspondingly electrically connected to one transistor group.

6. The memory according to claim 5, wherein the plurality of second control lines are arranged in the second direction, and each second control line extends in the first direction, wherein
each transistor in the transistor group corresponds to one second control line, transistor groups located at odd-numbered positions in the first direction share a second control line, and transistor groups located at even-numbered positions in the first direction share a second control line.

7. The memory according to claim 6, wherein the second control line is in a straight line shape, and the second control line electrically connected to each transistor group located at the odd-numbered position in the first direction is different from the second control line electrically connected to each transistor group located at the even-numbered position in the first direction.

8. The memory according to claim 6, wherein the second control line is in a straight line shape or a sawtooth shape, and two adjacent rows of transistors in the second direction share the second control line.

9. The memory according to claim 5, wherein the plurality of second control lines are arranged in a third direction, and each second control line extends in a fourth direction, wherein the third direction is perpendicular to the fourth direction, and an included angle between the fourth direction and the second direction is 60 degrees; and
each transistor in the transistor group corresponds to one second control line, and each transistor group located at an odd-numbered position in the first direction and each transistor group located at an even-numbered position in the first direction share at least a part of the second control line.

10. The memory according to any one of claims 1 to 9, wherein for the plurality of selection signal lines corresponding to each layer of memory array,
the plurality of selection signal lines are arranged in the second direction, and each selection signal line extends in the first direction; or
the plurality of selection signal lines are arranged in the first direction, and each selection signal line extends in the second direction.

11. The memory according to claim 10, wherein the plurality of selection signal lines corresponding to each layer of memory array are interconnected.

12. A memory, comprising at least one layer of memory array, wherein
each layer of memory array in the at least one layer of memory array corresponds to a plurality of first control lines, a plurality of second control lines, a plurality of third control lines, and a plurality of fourth control lines;
each layer of memory array in the at least one layer of memory array comprises a plurality of memory cell groups arranged in a first direction, wherein each memory cell group comprises a plurality of memory cells arranged at an equal distance in a second direction, adjacent memory cell groups are arranged in a staggered manner in the second direction, and the first direction is perpendicular to the second direction;
each memory cell comprises a first transistor and a second transistor that are disposed in a stacked manner, and a gate electrode of the first transistor is electrically connected to a first electrode of the second transistor;
a second electrode and a first electrode of each first transistor are electrically connected to one first control line and one second control line respectively, and at least one control line of first control lines and second control lines that are electrically connected to any two first transistors is different; and
a gate electrode and a first electrode of each second transistor are electrically connected to one third control line and one fourth control line respectively, and at least one control line of third control lines and fourth control lines that are electrically connected to any two second transistors is different.

13. The memory according to claim 12, wherein in the memory array, a distance at which memory cells at corresponding positions in the adjacent memory cell groups are staggered in the second direction is equal to half of a distance between centers of two adjacent memory cells in a same memory cell group; and
in the adjacent memory cell groups, a distance between centers that are of the memory cells belonging to different memory cell groups and that are in the first direction is equal to the distance between the centers of the two adjacent memory cells in the same memory cell group.

14. The memory according to claim 12 or 13, wherein both the first transistor and the second transistor comprise a gate electrode, a gate oxygen medium, a semiconductor channel material, a first electrode, an insulation medium, and a second electrode, wherein
the gate electrode comprises a columnar portion extending in a stacking direction of the memory and a planar portion located at one end of the columnar portion; the gate oxygen medium and the semiconductor channel material sequentially wrap an outer side of the columnar portion; the first electrode surrounds or partially surrounds the semiconductor channel material, and the first electrode is located near the planar portion; the second electrode is located at one end of the columnar portion away from the planar portion, and the second electrode and the columnar portion are spaced by the gate oxygen medium and the semiconductor channel material; and the insulation medium is disposed between the first electrode and the second electrode; and
the gate electrode of the first transistor is disposed facing the second electrode of the second transistor, and the gate electrode of the first transistor is electrically connected to the second electrode of the second transistor.

15. The memory according to any one of claims 12 to 14, wherein in the memory array, the plurality of first control lines are arranged in the first direction, each first control line extends in the second direction, and each first control line is correspondingly electrically connected to one memory cell group; and
in the memory array, the plurality of third control lines are arranged in the first direction, each third control line extends in the second direction, and each third control line is correspondingly electrically connected to one memory cell group.

16. The memory according to claim 15, wherein in the memory array,
the plurality of second control lines are arranged in the second direction, and each second control line extends in the first direction, wherein each first transistor in the memory cell group corresponds to one second control line, memory cell groups located at odd-numbered positions in the first direction share a second control line, and memory cell groups located at even-numbered positions in the first direction share a second control line; and
the plurality of fourth control lines are arranged in the second direction, and each fourth control line extends in the first direction, wherein each second transistor in the memory cell group corresponds to one fourth control line, memory cell groups located at odd-numbered positions in the first direction share a fourth control line, and memory cell groups located at even-numbered positions in the first direction share a fourth control line.

17. The memory according to claim 16, wherein in the memory array, the second control line is in a straight line shape, and the second control line electrically connected to each memory cell group located at the odd-numbered position in the first direction is different from the second control line electrically connected to each memory cell group located at the even-numbered position in the first direction.

18. The memory according to claim 16, wherein in the memory array, the second control line is in a straight line shape or a sawtooth shape, and two adjacent rows of memory cells in the second direction share the second control line.

19. The memory according to claim 16, wherein in the memory array, the fourth control line is in a straight line shape, and the fourth control line electrically connected to each memory cell group located at the odd-numbered position in the first direction is different from the fourth control line electrically connected to each memory cell group located at the even-numbered position in the first direction.

20. The memory according to claim 16, wherein in the memory array, the fourth control line is in a straight line shape or a sawtooth shape, and two adjacent rows of memory cells in the second direction share the fourth control line.

21. The memory according to claim 15, wherein in the memory array, the plurality of second control lines are arranged in a third direction, and each second control line extends in a fourth direction, wherein the third direction is perpendicular to the fourth direction, and an included angle between the fourth direction and the second direction is 60 degrees; and
each first transistor in the memory cell group corresponds to one second control line, and each memory cell group located at an odd-numbered position in the first direction and each memory cell group located at an even-numbered position in the first direction share at least a part of the second control line.

22. The memory according to claim 15, wherein in the memory array, the plurality of fourth control lines are arranged in a third direction, and each fourth control line extends in a fourth direction, wherein the third direction is perpendicular to the fourth direction, and an included angle between the fourth direction and the second direction is 60 degrees; and
each second transistor in the memory cell group corresponds to one fourth control line, and each memory cell group located at an odd-numbered position in the first direction and each memory cell group located at an even-numbered position in the first direction share at least a part of the fourth control line.

23. An electronic device, comprising a processor, and the memory that is coupled to the processor and that is according to any one of claims 1 to 22.
